(19) Europäisches Patentamt
European Patent Office
Office européen des brevets

(11) **EP 1 221 253 B1**

(12) **EUROPÄISCHE PATENTSCHRIFT**

(45) Veröffentlichungstag und Bekanntmachung des Hinweises auf die Patenterteilung:
**12.03.2008 Patentblatt 2008/11**

(21) Anmeldenummer: **00990669.4**

(22) Anmeldetag: **07.12.2000**

(51) Int Cl.:
**H04M 11/06** *(2006.01)*

(86) Internationale Anmeldenummer:
**PCT/EP2000/012333**

(87) Internationale Veröffentlichungsnummer:
**WO 2001/043414 (14.06.2001 Gazette 2001/24)**

(54) **TIEFPASS FÜR EINE ADSL-FREQUENZWEICHE**

LOW PASS FOR AN ADSL FREQUENCY FILTER

FILTRE PASSE-BAS POUR UN FILTRE DE FREQUENCE ADSL

(84) Benannte Vertragsstaaten:
**DE ES FR GB IT**

(30) Priorität: **10.12.1999 DE 19959724**

(43) Veröffentlichungstag der Anmeldung:
**10.07.2002 Patentblatt 2002/28**

(73) Patentinhaber: **Vacuumschmelze GmbH & Co. KG**
**63450 Hanau (DE)**

(72) Erfinder: **HEUMANN, Dirk**
**61130 Nidderau (DE)**

(74) Vertreter: **Schmuckermaier, Bernhard**
**Herzog-Wilhelm-Str. 26**
**80331 München (DE)**

(56) Entgegenhaltungen:
**EP-A- 0 063 414    EP-A- 0 677 938**
**US-A- 4 456 985**

**Beschreibung**

Die Erfindung betrifft eine Filteranordnung mit jeweils paarweise angeordneten, sich zwischen Anschlüssen der Filteranordnung erstreckenden und Induktivitäten aufweisenden Längszweigen und mit wenigstens einem sich zwischen den Längszweigen erstreckenden, wenigstens eine Kapazität aufweisenden Querzweig.

Derartige Filteranordnungen sind aus dem Handbuch Anatol I. Zverev, "Handbook of Filter Synthesis", 1967, bekannt. Die bekannten Filteranordnungen lassen sich zu Frequenzweichen zusammensetzen. Wenn beispielsweise ein Tiefpaß und ein Hochpaß parallel geschaltet sind, werden hochfrequente Signale über den mit einem Hochpaß versehenen Filterzweig und niederfrequente Signale über den mit einem Tiefpaß ausgestatteten Filterzweig geleitet. Im ADSL-Telekommunikationssystem erfolgt nun die Verbindung zwischen einer ADSL-fähigen digitalen Ortsvermittlungsstelle und dem ADSL-Modem, das gleich dem teilnehmerseitigen Netzabschluß ist, über eine öffentliche Zweidrahtleitung. ADSL steht dabei für "Asymmetric Digital Subscriber Line". Zeitgleich können über dieselbe Zweidrahtleitung POTS- und ISDN-Verbindungen laufen. POTS steht dabei für "Plain Old Telefone System" und ISDN für "Integrated Services Digital Network". Die Trennung und Übertragung der niederfrequenten POTS- oder ISDN-Komponenten von den ADSL-Komponenten wird durch Filterweichen bewirkt, die an den Enden der öffentlichen Zweidrahtleitungen sitzen. Die niederfrequenten POTS- oder ISDN-Komponenten werden dabei über einen Tiefpaß in einen Tiefpaßzweig gelenkt, während die hochfrequenten ADSL-Komponenten über einen Hochpaß in einen Hochpaßzweig geführt werden. Ein für den Einsatz in einer ADSL-Filterweiche geeigneter Tiefpaß muß bestimmten Anforderungen bezüglich der Übertragungsfunktion, der Gruppenlaufzeitverzerrung und der Reflexionsdämpfung genügen. Im Durchlaßbereich wird insbesondere eine möglichst hohe Reflexionsdämpfung angestrebt. Beispielsweise soll die Reflexionsdämpfung im POTS-Durchlaßbereich von 200 Hz bis 4 kHz > 18 dB betragen sowie bei 16 kHz > 14 dB sein. Die bekannten Filter genügen diesen Anforderungen nicht.

Dokument EP-A-0677938 offenbart eine Filteranordnung mit einer verstellbaren Impedanz und einer Steuereinheit. Die Steuereinheit führt die verstellbare Impedanz zwischen zwei Einstellungen, einer Einstellung mit null Impedanz und einer anderen Einstellung mit einer RC-Impedanz. Die Steuereinheit schaltet zwischen diesen zwei Werten, um die Sättigungsgrenze der Induktivitäten und Kapazitäten nicht zu überschreiten.

Dokumente US-A-0063414 und US-A-4456985 offenbaren Tiefpass-Filteranordnungen mit einem auf Blindkomponenten basierenden Parallelresonanzkreis. Diese Filteranordnung setzt sich das Ziel, die variable Impedanz der Telefonleitung zu verhindern.

Eine bekannte Filteranordnung weist mehrere hintereinander geschaltete Filterstufen auf. Ferner weist die symmetrische Filteranordnung zwei Längszweige auf, die jeweils aus mehreren in Reihe geschalteten Induktivitäten bestehen. Die Filterstufen umfassen jeweils eine der Induktivitäten des einen Längszweigs und eine der Induktivitäten des anderen Längszweigs sowie ein zwischen den Längszweigen geschalteten Querzweig, der zwei Induktivitäten und einen dazwischen geschalteten Kondensator aufweist.

Ausgehend von diesem Stand der Technik liegt der Erfindung die Aufgabe zugrunde, eine Filteranordnung mit verbesserter Reflexionsdämpfung zu schaffen, die auch die Anforderungen bezüglich der Übertragungsfunktion und der Gruppenlaufzeitverzerrung erfüllt.

Diese Aufgabe wird durch eine Filteranordnung gelöst, die sich zwischen Anschlüssen der Filteranordnung erstreckende und Induktivitäten aufweisende Längszweige aufweist. Ferner weist die Filteranordnung mindestens zwei Filterstufen auf, denen jeweils verschiedene der Induktivitäten der Längszweige zugeordnet sind und von denen mindestens eine Filterstufe einen sich zwischen zwei der Längszweige erstreckenden, wenigstens eine Kapazität aufweisenden Querzweig aufweist. Zu mindestens einer aber nicht allen Filterstufen gehörende Induktivitäten der Längszweige sind in Filterbaugruppen angeordnet, die jeweils mindestens eine Induktivität mit einem parallel zur Induktivität geschalteten reellen Widerstand umfassen.

Bei einer Filteranordnung mit z.B. 4 Anschlüssen, d.h. mit zwei Längszweigen, werden also zwei Induktivitäten der zwei Längszweige, die zur selben Filterstufe einer herkömmlichen Filteranordnung gehören, bei einer erfindungsgemäßen Filteranordnung durch die Filterbaugruppen ersetzt. Bei einer Filteranordnung mit z.B. 6 Anschlüssen, d.h. mit drei Längszweigen, wird also von jedem Längszweig eine Induktivität, die zur selben Filterstufe einer herkömmlichen Filteranordnung gehört, bei einer erfindungsgemäßen Filteranordnung durch die Filterbaugruppe ersetzt. Es werden in diesem Fall drei Induktivitäten der drei Längszweige durch die Filterbaugruppen ersetzt.

Zwischen jeweils zwei Längszweige ist bei der mindestens einen Filterstufe ein Querzweig geschaltet. Bei drei Längszweigen weist die Filterstufe drei Querzweige auf. Bei zwei Längszweigen weist die Filterstufe einen Querzweig auf.

Aufgrund des parallel geschalteten reellen Widerstands in der Filterbaugruppe läßt sich der Abschlußwiderstand der Filteranordnung an einen komplexen Leitungswiderstand anpassen, so daß sich für die Filteranordnung eine hohe Reflexionsdämpfung im Arbeitsbereich ergibt. Da nicht alle Filterstufen solche Filterbaugruppen aufweisen, ist die Einfügedämpfung, d.h. der Energieverlust in der Filteranordnung, nicht sehr hoch.

Um die Einfügedämpfung zu minimieren, weist vorzugsweise nur eine Filterstufe besagte Filterbaugruppen auf. Es hat sich gezeigt, daß bereits bei nur einer Filterbaugruppen aufweisende Filterstufe die Reflexionsdämpfung stark erhöht ist.

Es liegt im Rahmen der Erfindung mehr als eine Filterstufe vorzusehen, die besagte Filterbaugruppen aufweisen.

Der komplexe Abschlußwiderstand kann durch ohmsche Widerstände mit den Werten R1 und R2 dargestellt werden, wobei eine Kapazität parallel zum ohmschen Widerstand mit dem Wert R2 geschaltet ist. Ist R1 wesentlich kleiner als R2, so weist die Filterbaugruppe zur Verkleinerung der Einfügedämpfung vorzugsweise nur eine Induktivität auf. Diese Induktivität ist parallel zum Widerstand geschaltet.

Ist R1 nicht wesentlich kleiner als R2, so umfaßt die Filterbaugruppe zur Erhöhung der Reflexionsdämpfung in Reihe geschaltete Induktivitäten mit einem parallel zu einer der Induktivitäten geschalteten reellen Widerstand.

Zur weiteren Erhöhung der Reflexionsdämpfung kann zu einer Induktivität eines Querzweigs ein weiterer reeller Widerstand parallel geschaltet sein. Es können auch weitere Querzweige auf diese Weise transformiert werden.

Die Längszweige sind vorzugsweise symmetrisch aufgebaut. Weist z.B. eine Filterstufe zwei Induktivitäten desselben Längszweigs auf, so weist die Filterstufe zwei entsprechende Induktivitäten von jedem anderen der Längszweige auf.

Vorzugsweise sind die sich entsprechenden Induktivitäten der Längszweige um jeweils denselben Magnetkern gewickelt. Dadurch sind diese Induktivitäten miteinander verkoppelt.

Der Querzweig ist beispielsweise von einer Reihenschaltung von Induktivitäten und Kapazitäten gebildet. Beispielsweise ist der Querzweig von zwei Induktivitäten gebildet, zwischen denen eine Kapazität angeordnet ist. Wird ein solcher Querzweig transformiert, so ist zu jedem der beiden Induktivitäten ein weiterer reeller Widerstand parallel geschaltet

Die Induktivitäten im Querzweig sind vorzugsweise von auf einen gemeinsamen Magnetkern gewickelten Wicklungen gebildet.

Nachfolgend wird die Erfindung anhand der beigefügten Zeichnung näher beschrieben. Es zeigen:

Figur 1      eine Übersicht über die Verbindung zwischen einer Ortsvermittlungsstelle und einem teilnehmerseitigen Netzabschluß;

Figur 2      eine herkömmliche aus Induktivitäten und Kapazitäten zusammengesetzte Tiefpaßfilteranordnung;

Figur 3      ein Ersatzschaltbild für den komplexen Leitungswiderstand der öffentlichen Zweidrahtleitung;

Figur 4      eine Darstellung der zur Umwandlung des herkömmlichen Tiefpaßfilters aus Figur 2 notwendigen Transformation; und

Figur 5      ein erstes Tiefpaßfilter, das an den komplexen Leitungswiderstand aus Figur 3 angepaßt ist.

Figur 6      ein zweites Tiefpaßfilters, das an den komplexen Leitungswiderstand aus Figur 3 angepaßt ist.

Figur 7      eine Filterstufe eines dritten Tiefpaßfilters, das an den komplexen Leitungswiderstand aus Figur 3 angepaßt ist.

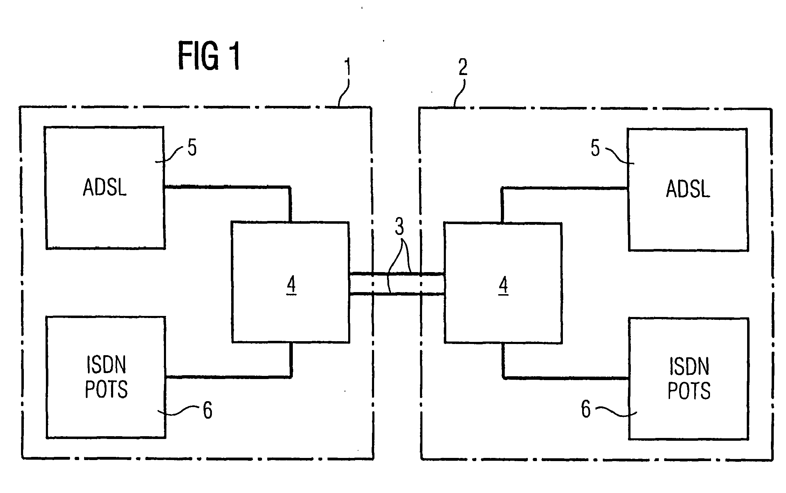

Figur 1 zeigt eine schematische Darstellung der Verbindung zwischen einer Ortsvermittlungsstelle 1 und einem teilnehmerseitigen Netzabschluß 2, die über eine öffentliche Zweidrahtleitung 3 untereinander verbunden sind. Am Ende der Zweidrahtleitung 3 sind Frequenzweichen 4 vorgesehen. Die über die öffentliche Zweidrahtleitung 3 laufenden hochfrequenten ADSL-Signale werden von den Frequenzweichen 4 in einen ADSL-Zweig 5 gelenkt, während die niederfrequenten POTS- und ISDN-Signale von den Frequenzweichen 4 jeweils in einen POTS-/ISDN-Zweig 6 gelenkt werden. Am Eingang des POTS-/ISDN-Zweigs 6 ist zweckmäßigerweise ein Tiefpaßfilter angeordnet.

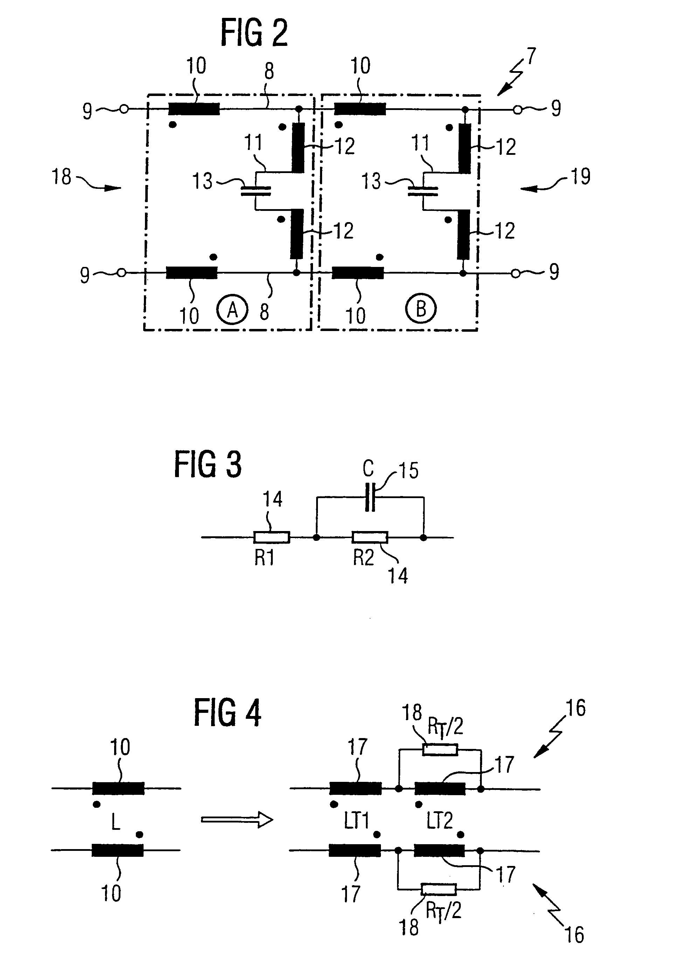

Figur 2 zeigt ein für den Einsatz im POTS-/ISDN-Zweig 6 bedingt geeignetes herkömmliches Tiefpaßfilter, das auf einen reellen Abschlußwiderstand ausgelegt ist. Das Tiefpaßfilter 7 aus Figur 2 ist ein symmetrisches Filter vierter Ordnung und weist paarweise angeordnete Längszweige 8 auf, die sich zwischen Anschlüssen 9 des Tiefpaßfilters 7 erstrecken. In den Längszweigen 8 sind Längsinduktivitäten 10 angeordnet. Jeweils zwei der in dem Schaltbild in Figur 2 gegenüberliegenden Induktivitäten 10 gehören zu einer Filterstufe A, B werden dabei von auf einen gemeinsamen Magnetkern mit gleichem Wicklungssinn aufgewickelten Spulen gebildet. Zwischen den Längszweigen 8 sind Querzweige 11 angeordnet, die jeweils zu einer der Filterstufen A, B gehören und die zwei Querinduktivitäten 12 und eine zwischen den Querinduktivitäten 12 angeordnete Kapazität 13 aufweisen. Die jeweils in einem Querzweig 11 vorhandenen Querinduktivitäten 12 sind von auf einen gemeinsamen Magnetkern im gleichen Wicklungssinn aufgewickelten Spulen gebildet. Durch die in den Querzweigen 11 vorhandene Kombination der Kapazität 13 und der Querinduktivitäten 12 werden Nullstellen der Übertragungsfunktion gebildet und der Abfall der Übertragungsfunktion oberhalb einer Grenzfrequenz verstärkt.

Das in Figur 2 dargestellte Tiefpaßfilter 7 ist auf einen reellen Abschlußwiderstand ausgelegt und vermag deshalb strengen Anforderungen an die Reflexionsdämpfung bei einem komplexen Leitungswiderstand nicht zu genügen.

Der Leitungswiderstand der öffentlichen Zweidrahtleitung 3 ist in Figur 3 für den Grenzfall kleiner Frequenzen durch ein Ersatzschaltbild veranschaulicht. Der Abschlußwiderstand kann durch ohmsche Widerstände mit den Werten R1 und R2 dargestellt werden, wobei eine Kapazität 15 mit dem Wert C parallel zum ohmschen Widerstand 14 mit dem Wert R2 geschaltet ist. Im folgenden soll für den komplexen Abschlußwiderstand der öffentlichen Zweidrahtleitung 3 gelten:

$$Z = R1 + R2 \left\| \frac{1}{i\omega C} \right. \tag{1}$$

Um nun das auf einen reellen Abschlußwiderstand R ausgelegte Tiefpaßfilter 7 in ein Tiefpaßfilter umzuwandeln, das an den komplexen Abschlußwiderstand der Zweidrahtleitung 3 vollständig angepaßt ist, ist es erforderlich, wie in Figur 4 dargestellt, die Induktivitäten 10 im Längskreis 8 durch Baugruppen 16 zu ersetzen, die jeweils über zwei Teilinduktivitäten 17 und einem zu einem der Teilinduktivitäten 17 parallel geschalteten reellen Teilwiderstand 18 verfügen.

Die vorgenommene Umwandlung läßt sich wie folgt begründen:

Betrachtet sei der Tiefpaßfilter 7 aus Figur 2, der einen reellen Wellenwiderstand

$$R = \sqrt{Z_O \cdot Z_G} \tag{2}$$

aufweist, wobei $Z_O$ die Impedanz des Tiefpaßfilters 7 mit offenem Ende und $Z_G$ die Impedanz des Tiefpaßfilters 7 bei kurzgeschlossenem Ende ist. Um nun das Tiefpaßfilter 7 auf den komplexen Abschlußwiderstand passiv zu transformieren, wird Gleichung (2) mit dem Faktor Z/R multipliziert. Es ergibt sich dann der Ausdruck:

$$Z = \sqrt{\frac{Z}{R} \cdot Z_O \cdot \frac{Z}{R} \cdot Z_G} \tag{3}$$

Bei einer beliebigen vierpoligen Filteranordnung nach Figur 2 ergibt sich beispielsweise die Impedanz $Z_O$ als Gesamtimpedanz zwischen den einen Eingang 18 bildenden Anschlüssen 9 bei offenen einen Ausgang 19 bildenden Anschlüssen 9. Die Gesamtimpedanz $Z_O$ ergibt sich dann bei Serienschaltung als eine Summe von Impedanzwerten oder bei Parallelschaltung als das Inverse der Summe von invertierten Impedanzwerten. Das gleiche gilt für die Berechnung der Gesamtimpedanz $Z_G$, die sich als die Impedanz zwischen den eingangsseitigen Anschlüssen 9 bei kurzgeschlossenen ausgangsseitigen Anschlüssen 9 ergibt. Nach dem Distributivgesetz kann der Transformationsfaktor Z/R in die Summen hineingezogen werden, so daß sich die Transformation des gesamten Tiefpaßfilters 7 auf eine Transformation der einzelnen das Tiefpaßfilter 7 bildenden Impedanzen reduziert. Für die Induktivitäten mit dem Wert L ergibt sich dann eine transformierte Impedanz

$$Z_{Trafo}(i\omega L) = \left( R1 + R2 \left\| \frac{1}{i\omega C} \right. \right) \frac{i\omega L}{R} \tag{4}$$

Dieser Ausdruck läßt sich umformen zu

$$Z_{Trafo}(i\omega L) = i\omega L_{T1} + i\omega L_{T2} \| R_T \tag{5}$$

mit

$$L_{T1} = \frac{R1}{R} \cdot L \qquad\qquad (6)$$

$$L_{T2} = \frac{R2}{R} \cdot L \qquad\qquad (7)$$

$$R_T = \frac{L}{CR} \qquad\qquad (8)$$

Berücksichtigt man, daß in dem Tiefpaßfilter 7 aus Figur 2 gegenüberliegende Induktivitäten von auf einem gemeinsamen Magnetkern mit gleichem Wicklungssinn Drosseln gebildet sind, ergibt sich schließlich die in Figur 4 dargestellte Transformation. Man beachte, daß in diesem Fall die Längsinduktivitäten 10 nicht unabhängig sind, sondern daß es sich dabei um auf einen gemeinsamen Magnetkern gewickelte Spulen handelt, die gemeinsam den Induktivitätswert L aufweisen. In gleicher Weise handelt es sich bei gegenüberliegenden Teilinduktivitäten 17 um auf einen gemeinsamen Magnetkern gewickelte Spulen die zusammen den Wert $L_{T1}$ und $L_{T2}$ aufweisen.

Es hat sich gezeigt, daß bereits bei einer Transformation von Induktivitäten 10 nur einer der Filterstufen A, B eine starke Erhöhung der Reflexionsdämpfung erzielt wird.

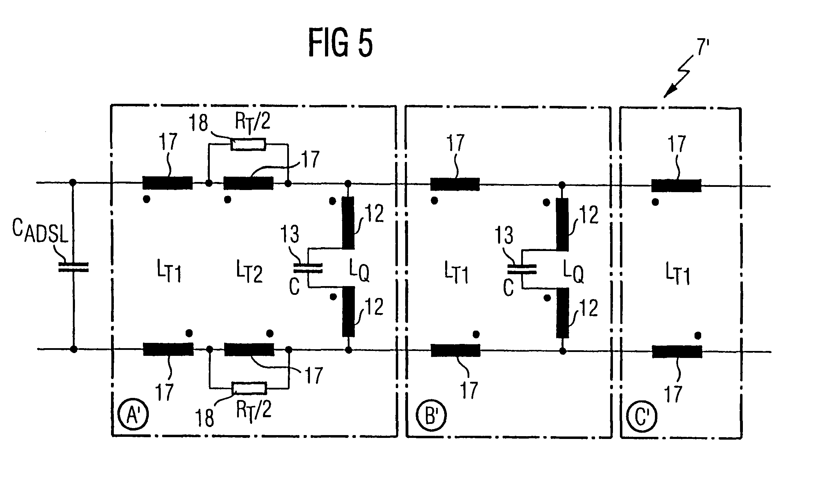

Ein nur in Teilen der Längszweige 8 einer ersten Filterstufe A' transformierter erster Tiefpaß 7' hat dann das in Figur 5 dargestellte Aussehen. Bei dem in Figur 5 dargestellten ersten Ausführungsbeispiel des an einen komplexen Abschlußwiderstand fast vollständig angepaßten ersten Filters 7' handelt es sich um ein Filter 6. Ordnung mit drei Filterstufen A', B', C'. Durch die Kapazität $C_{ADSL}$ wird der zum ADSL-Zweig 5 führende Hochpaß dargestellt. Mögliche Zahlenwerte, um das erste Tiefpaßfilter 7' an einen komplexen Abschlußwiderstand mit R1 = 220 Ω, R2 = 820 Ω und C = 115 nF anzupassen, sind in Tabelle 1 angegeben.

Tabelle 1:

| Bauelement | Stufe | Wert |
|---|---|---|
| $C_{ADSL}$ | | 6,8 nF |
| $L_{T1}$ | A' | 697 µH |
| $L_{T2}$ | A' | 2598 µH |
| $R_T$ | A' | 27,5 Ω |
| $L_Q$ | A' | 72 µH |
| C | A' | 11,7 nF |
| $L_{T1}$ | B' | 1088 µH |
| $L_Q$ | B' | 41 µH |
| C | B' | 10,5 nF |
| $L_{T1}$ | C' | 574 µH |

Es sei anmerkt, daß die Werte der einzelnen verkoppelten Längsinduktivitäten 17 jeweils gleich $L_{T1}$/4 oder $L_{T2}$/4 betragen. In gleicher Weise sind die Werte der einzelnen verkoppelten Querinduktivitäten 12 gleich $L_Q$/4.

Alternativ können die zweite oder die dritte Filterstufe transformiert sein. Auch Kombinationen von Filterstufen, z.B. die erste und die zweite Filterstufe, können transformiert sein.

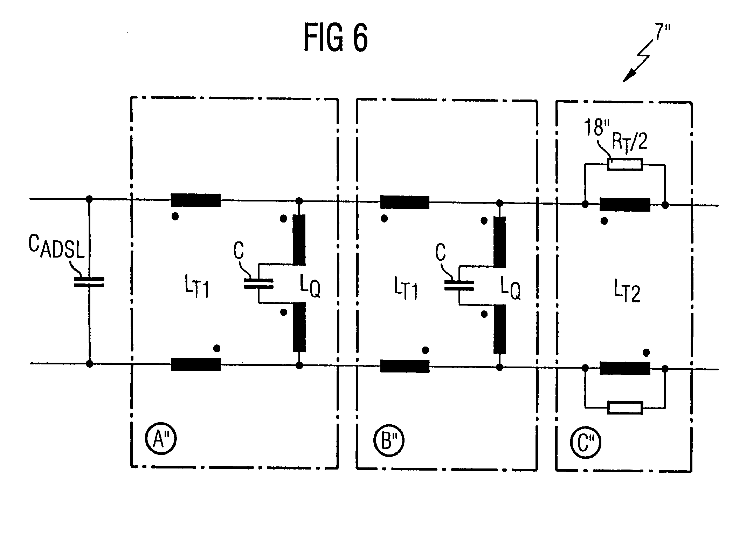

Bei einem zweiten in Figur 6 dargestellten Ausführungsbeispiel ist nur eine dritte Filterstufe C" aber nicht eine erste Filterstufe A" und nicht eine zweite Filterstufe B" transformiert. Ein weiterer Unterschied zum ersten Ausführungsbeispiel besteht darin, daß, da R1 mit einem Wert von 220 Ohm wesentlich kleiner als R2 ist, der einen Wert von 820 Ohm aufweist, in den Filterbaugruppen der dritten Filterstufe C" auf Längsinduktivitäten, die nicht zum Widerstand 18" parallel geschaltet sind, verzichtet werden. Mögliche Zahlenwerte, um das zweite Tiefpaßfilter 7" an die Abschlußwiderstände anzupassen, sind in Tabelle 2 angegeben.

Tabelle 2:

| Bauelement | Stufe | Wert |
|---|---|---|
| $C_{ADSL}$ | | 28 nF |
| $L_{T1}$ | A" | 8,84 mH |
| $L_Q$ | A" | 378 μH |
| C | A" | 43 nF |
| $L_{T1}$ | B" | 10,2 mH |
| $L_Q$ | B" | 244 μH |
| C | B" | 38 nF |
| $L_{T2}$ | C" | 12,32 mH |
| $R_T$ | C" | 78 Ohm |

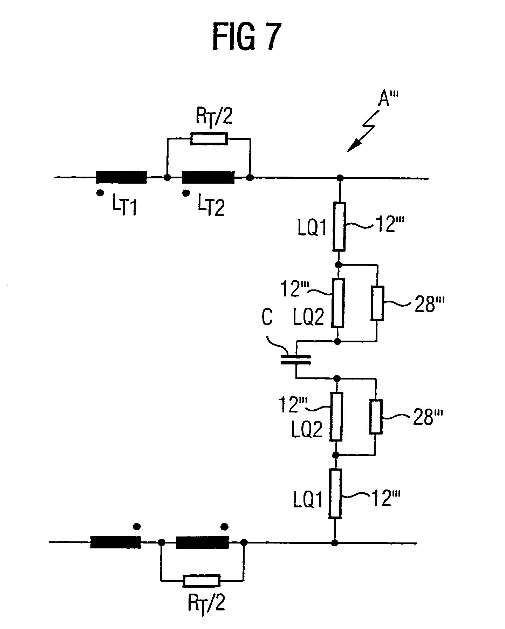

Für eine gute Reflexionsdämpfung reicht es aus, wenn Induktivitäten 10 in den Längszweigen 8 transformiert werden. Die Reflexionsdämpfung läßt sich jedoch dadurch weiter verbessern, wenn auch Induktivitäten 12 in den Querzweigen 11 der in Figur 4 dargestellten Transformation unterzogen werden. Figur 7 zeigt eine Filterstufe A''' eines dritten Filters mit einer durch einen weiteren reellen Widerstand 28''' transformierten Querinduktivität 12'''.

Die Kapazitäten 13 in den Querzweigen 11 können nicht mit Z/R transformiert werden, da die entstehenden Impedanzfunktion keine Zweipolfunktion sind, denn die sich ergebenden Impedanzfunktion weisen in der rechten Halbebene der komplexen S-Ebene Nullstellen auf. Somit kann die sich ergebende Impedanzfunktion nicht in Einzelkomponenten zerlegt werden. Die Kapazitäten 13 in den Querzweigen 11 spielen für die Reflexionsdämpfung nur im sehr niederfrequenten Bereich eine Rolle, da sie für hohe Frequenzen durchlässig sind. Liegen die Werte für die Kapazitäten 13 unterhalb eines Maximalwertes, müssen sie nicht berücksichtigt werden. Insofern reicht es aus, nur die Induktivitäten zu transformieren.

**Patentansprüche**

1. Filteranordnung mit sich zwischen Anschlüssen (9) der Filteranordnung erstreckenden und Induktivitäten (17) aufweisenden Längszweigen (8) und mit mindestens zwei Filterstufen (A', B', C'), denen jeweils verschiedene der Induktivitäten (17) der Längszweige (8) zugeordnet sind und von denen mindestens eine Filterstufe (A', B') einen sich zwischen zwei der Längszweige (8) erstreckenden, wenigstens eine Kapazität (13) aufweisenden Querzweig (11) aufweist,
**dadurch gekennzeichnet,**
**daß** zu mindestens einer aber nicht allen Filterstufen (A') gehörende Induktivitäten (17) der Längszweige (8) in Filterbaugruppen (16) angeordnet sind, die mindestens eine Induktivität (17) mit einem parallel zur Induktivität (17) geschalteten reellen Widerstand (18) umfassen.

2. Filteranordnung nach Anspruch 1,
**dadurch gekennzeichnet,**
**daß** die Filterbaugruppen (16) jeweils in Reihe geschaltete Induktivitäten (17) mit einem parallel zu einer der Induktivitäten (17) geschalteten reellen Widerstand (18) umfassen.

3. Filteranordnung nach Anspruch 1 oder 2,
**dadurch gekennzeichnet,**
**daß** bei den vorhandenen Längszweigen (8) die Anordnung der Filterbaugruppen (16) und der Induktivitäten (17) übereinstimmt.

4. Filteranordnung nach einem der Ansprüche 1 bis 3,
**dadurch gekennzeichnet,**
**daß** jeder Querzweig (11) von einer Reihenschaltung von Induktivitäten (12) und Kapazitäten (13) gebildet ist.

**5.** Filteranordnung nach Anspruch 4,
**dadurch gekennzeichnet,**
**daß** jeder Querzweig (11) von zwei Induktivitäten (12) gebildet ist, zwischen denen eine Kapazität (13) angeordnet ist.

**6.** Filteranordnung nach einem der Ansprüche 3 bis 5,
**dadurch gekennzeichnet,**
**daß** sich entsprechende Induktivitäten (17) der Längszweige (8) von auf einen gemeinsamen Magnetkern gewikkelten Wicklungen gebildet sind.

**7.** Filteranordnung nach einem der Ansprüche 4 bis 6,
**dadurch gekennzeichnet,**
**daß** die Induktivitäten (12) im Querzweig (11) von auf einen gemeinsamen Magnetkern gewickelten Wicklungen gebildet sind.

**8.** Filteranordnung nach einem der Ansprüche 4 bis 7,
**dadurch gekennzeichnet,**
**daß** die Induktivitäten (12''') des Querzweigs jeweils parallel zu einem weiteren reellen Widerstand (18''') geschaltet sind.

## Claims

**1.** A filter arrangement with longitudinal branches (8), which include inductances (17) and extend between connections (9) of the filter arrangement, and with at least two filter stages (A', B', C'), with which different ones of the inductances (17) of the longitudinal branches (8) are respectively associated and of which at least one filter stage (A', B') has a transverse branch (11), which has at least one capacitance (13) and extends between two of the longitudinal branches (8), **characterised in that** inductances (17) of the longitudinal branches (8) belonging to at least one but not all of the filter stages (A') are arranged in filter assemblies (16), which include at least one inductance (17) with a real resistance (18) connected in parallel with the inductance (17).

**2.** A filter arrangement as claimed in Claim 1, **characterised in that** the filter assemblies (16) each include inductances (17) connected in series with a real resistance (18) connected in parallel with one of the inductances (17).

**3.** A filter arrangement as claimed in Claim 1 or 2, **characterised in that** the arrangement of the filter assemblies (16) and the inductances (17) is the same in the longitudinal branches (8) that are present.

**4.** A filter arrangement as claimed in one of Claims 1 to 3, **characterised in that** each transverse branch (11) is constituted by a series connection of inductances (12) and capacitances (13).

**5.** A filter arrangement as claimed in Claim 4, **characterised in that** each transverse branch (11) is constituted by two inductances (12), between which is arranged a capacitance (13).

**6.** A filter arrangement as claimed in one of Claims 3 to 5, **characterised in that** corresponding inductances (17) of the longitudinal branches (8) are constituted by windings wound onto a common magnetic core.

**7.** A filter arrangement as claimed in one of Claims 4 to 6, **characterised in that** the inductances (12) in the transverse branch (11) are constituted by windings wound onto a common magnetic core.

**8.** A filter arrangement as claimed in one of Claims 4 to 7, **characterised in that** the inductances (12''') of the transverse branch are each connected in parallel with a further real resistance (18''').

## Revendications

**1.** Dispositif de filtre comprenant entre des raccords (9) du dispositif de filtre, des branches longitudinales (8) présentant des inductances (17), et au moins deux étages de filtre (A', B', C'), dont différents étages respectifs sont associés aux inductances (17) des branches longitudinales (8) et dont au moins un étage de filtre (A', B') présente une branche transversale (11) qui s'étend entre deux des branches longitudinales (8) et qui présente au moins une capacité (13),
**caractérisé en ce que**
des inductances (17) des branches longitudinales (8) appartenant au moins à un étage de filtre (A') mais non à tous sont disposées dans des modules de filtre (16) qui comprennent au moins une inductance (17) avec une résistance réelle (18) connectée parallèlement à l'inductance (17).

2. Dispositif de filtre selon la revendication 1,
**caractérisé en ce que**
les modules de filtre (16) comprennent respectivement des inductances (17) connectées en série, avec une résistance réelle (18) connectée en parallèle à l'une des inductances (17).

3. Dispositif de filtre selon la revendication 1 ou 2,
**caractérisé en ce que**
pour les branches longitudinales présentes (8), la disposition des modules de filtre (16) et des inductances (17) coïncide.

4. Dispositif de filtre selon l'une des revendications 1 à 3,
**caractérisé en ce que**
chaque branche transversale (11) est formée par un circuit en série d'inductances (12) et de capacités (13).

5. Dispositif de filtre selon la revendication 4,
**caractérisé en ce que**
chaque branche transversale (11) est formée par deux inductances (12) entre lesquelles est disposée une capacité (13).

6. Dispositif de filtre selon l'une des revendications 3 à 5,
**caractérisé en ce que**
des inductances (17) des branches longitudinales (8) qui se correspondent sont formées par des enroulements enroulés sur un noyau magnétique commun.

7. Dispositif de filtre selon l'une des revendications 4 à 6,
**caractérisé en ce que**
les inductances (12) dans la branche transversale (11) sont formées par des enroulements enroulés sur un noyau magnétique commun.

8. Dispositif de filtre selon l'une des revendications 4 à 7,
**caractérisé en ce que**
les inductances (12''') de la branche transversale sont connectées respectivement parallèlement à une autre résistance réelle (18''').

FIG 1

# FIG 2

# FIG 3

# FIG 4

# FIG 5

EP 1 221 253 B1

FIG 6

# FIG 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0677938 A
- US 0063414 A
- US 4456985 A

**In der Beschreibung aufgeführte Nicht-Patentliteratur**

- **HANDBUCH ANATOL I. ZVEREV.** Handbook of Filter Synthesis. 1967